# EUROPEAN PATENT APPLICATION

(11) **EP 4 583 133 A1**
(43) Date of publication of application: **09.07.2025**
(21) Application number: 24223271.8
(22) Date of filing: 24.12.2024
(51) Int. Cl.: H01H 1/00, H01H 33/56

(54) **SEALED HIGH CURRENT SWITCH WITH INTERNAL GAS MONITOR**

(30) Priority: 03.01.2024 US 202418403192
(71) Applicant: Honeywell International Inc., Charlotte, NC 28202 (US)
(72) Inventor: BORK, Stephan Michael, Charlotte, 28202 (US); HAF, Kevin, Charlotte, 28202 (US); BROWN, Andy Walker, Charlotte, 28202 (US)
(74) Representative: Haseltine Lake Kempner LLP

(57) **Abstract**

A high current switch comprising one or more of a gas composition sensor or a gas ionization sensor configured to (i) determine a condition associated with the current switch and (ii) generate respective one or more of a gas data signal or a ionization data signal; and a plurality of switch contacts configured to (i) receive a control signal from a system controller and (ii) switch a current input to a current output based on the control signal, wherein the control signal is generated by the system controller based at least in part on one or more of the gas data signal or the ionization data signal.

## Description

### FIELD OF THE INVENTION

Example embodiments of the present disclosure relate generally to switch devices for high current applications, and in particular, switch devices capable of detecting performance degrading conditions.

### BACKGROUND

Usage of high current switches, such as contactors, are increasingly more pervasive due to growing electrification of many applications, such as electric vehicles. A traditional high current switch may comprise heavy, material intensive, expensive structures filled with a gas mixture, such as hydrogen and/or nitrogen. That is, safety of a traditional high current switch is ensured by oversizing, sealing processes, and conservative operating points.

Applicant has identified technical improvements to traditional high current switches thereby allowing for more aggressive operation, smaller footprint, and improved performance.

### BRIEF SUMMARY

Various embodiments described herein relate to components, apparatuses, and systems comprising one or more high current switches and methods for managing operations of an electronics system based on monitoring of the one or more high current switches.

In accordance with various embodiments of the present disclosure, a current switch is provided. In some embodiments, the current switch comprises one or more of a gas composition sensor or a gas ionization sensor configured to (i) determine a condition associated with the current switch and (ii) generate respective one or more of a gas data signal or a ionization data signal; and a plurality of switch contacts configured to (i) receive a control signal from a system controller and (ii) switch a current input to a current output based on the control signal, wherein the control signal is generated by the system controller based at least in part on one or more of the gas data signal or the ionization data signal.

In some embodiments, the condition is representative of degradation, wear, or damage to an assembly comprising the current switch. In some embodiments, the gas composition sensor comprises a micro-electromechanical system sensor. In some embodiments, the gas ionization sensor comprises an ionization detection component of a photoionization detector gas sensor. In some embodiments, the gas ionization sensor comprises an optical monitoring device including a a photosensitive sensor or a photodetector. In some embodiments, the gas ionization sensor comprises a photosensitive sensor configured to monitor brightness and/or duration of arcing caused by the plurality of switch contacts. In some embodiments, the gas ionization sensor comprises a spectrometer or one or more spectral filters configured to determine spectral content of arcing caused by the plurality of switch contacts. In some embodiments, the current switch further comprises an assembly that encapsulates one or more of the gas composition sensor or the gas ionization sensor. In some embodiments, the gas composition sensor comprises a sensor configured to determine a presence and/or concentration of one or more gases in the assembly. In some embodiments, the gas data signal is representative of a presence and/or concentration of one or more gases in the assembly. In some embodiments, a gas ionization sensor comprises a sensor configured to determine a presence and/or amount of ionization in the assembly. In some embodiments, the control signal is associated with opening or closing of the plurality of switch contacts.

In accordance with various embodiments of the present disclosure, the method comprises receiving, by one or more processors, system data, the system data comprising a gas data signal and/or an ionization data signal from a current switch; determining, by the one or more processors, one or more of (i) a presence or amount of ionization or (ii) a change in gas composition, is greater than a threshold based on the system data; adjusting, by the one or more processors, performance of an electronics system by generating a control signal based on the determination that the presence or amount of ionization or the change in gas composition is greater than the threshold; and transmitting the control signal to the current switch.

In some embodiments, the system data comprises one or more of an input current or voltage with respect to the current switch, a direct current transient ramp speed, or an alternating current zero transition. In some embodiments, the method further comprises determining one or more of (i) an indication of a leaking seal associated with the current switch, (ii) a broken seal associated with the current switch, (iii) one or more alarms responsive to the system data, or (iv) a trend leading to ionization associated with the current switch. In some embodiments, the method further comprises increasing performance of the electronics system based on an absence of the determination that the presence or amount of ionization or the change in gas composition is greater than the threshold. In some embodiments, increasing performance of the electronics system comprises switching of direct current at higher levels or switching of alternating current with greater offset from zero transition. In some embodiments, adjusting performance of the electronics system comprises decreasing an input voltage or current. In some embodiments, adjusting performance of the electronics system comprises decreasing direct current transient ramp speed or alternative current zero transition. In some embodiments, adjusting performance of the electronics system comprises determining a rate of opening or closing a plurality of switch contacts associated with the current switch.

The foregoing illustrative summary, as well as other exemplary objectives and/or advantages of the disclosure, and the manner in which the same are accomplished, are further explained in the following detailed description and its accompanying drawings.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 illustrates an example electrical system in accordance with various embodiments of the present disclosure;
FIG. 2 illustrates an example computing entity in accordance with various embodiments of the present disclosure;
FIG. 3 illustrates a high current switch in accordance with various embodiments of the present disclosure; and
FIG. 4 illustrates an example flow diagram of a method for monitoring and controlling an electronics system in accordance with some example embodiments of the present disclosure.

### DETAILED DESCRIPTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc., are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

Various example embodiments of the present disclosure provide various technical advancements and improvements to traditional high current switches. In accordance with various examples of the present disclosure, components of example high current switches for improving high current switch performance are disclosed. As described herewith, embodiments of the present disclosure provide apparatuses and methods for detecting and measuring changes in an operating environment. In some embodiments, the operating environment comprises a hermetically sealed high current switch.

Hermetically sealing a high current switch and/or filling it with a specific gas/gas mixture can reduce damage to contacts from arcing, increase voltage rating, and generally improve contact life of the high current switch. Isolation properties of gas mixtures used in sealed high current switches are distinctively different from ambient air and can be measured with gas composition sensors. According to various embodiments of the present disclosure, a sealed switch comprises a gas composition sensor, an ionization sensor, and a system controller. A gas composition sensor inside a sealed high current switch may detect if the seal is broken thereby resulting in a change of gas composition within the high current switch. In some embodiments, a micro-electromechanical system (MEMS)-based gas sensor may be configured to detect changes in gas composition within a sealed high circuit switch. For example, changes from gases, such as hydrogen, may have distinctively different thermal conductivity properties than ambient air. In some embodiments, a system controller receives and monitors input data from a gas composition sensor associated with a high current switch to detect a change in gas composition that indicates a broken seal. Once a broken seal is detected, an alarm signal may be issued and/or the system controller can modify the operating point of the high current switch to lower current levels to continue operation of a system using the high current switch at lower performance levels until repairs can be made.

In some embodiments, the system controller receives an input from the ionization sensor to detect presence and amount of ionization, which may be associated with arcing conditions. The system controller may also control other system parameters, such as direct current (DC) transient ramp speed of an electrical current level to reduce stress on the high current switch and operate at a point where sparks or arcs are reduced. In some embodiments, a gas composition sensor inside the sealed switch may detect when sparks or arcs are present which cause ionization of gases within the sealed high current switch. In some embodiments, providing information about the presence and amount of ionization of a high current switch to a system controller may allow system management, for example, of an electric vehicle, to run certain components associated with the high current switch at a more aggressive operating point (e.g., switching at higher DC currents or switching with more time offset to zero pass voltage or current in an alternating current (AC) system). As such, some embodiments of the present disclosure enable smaller and lighter high current switches configurable to be operated at more aggressive operating points to improve system level performance of an electric vehicle including range as well as safety.

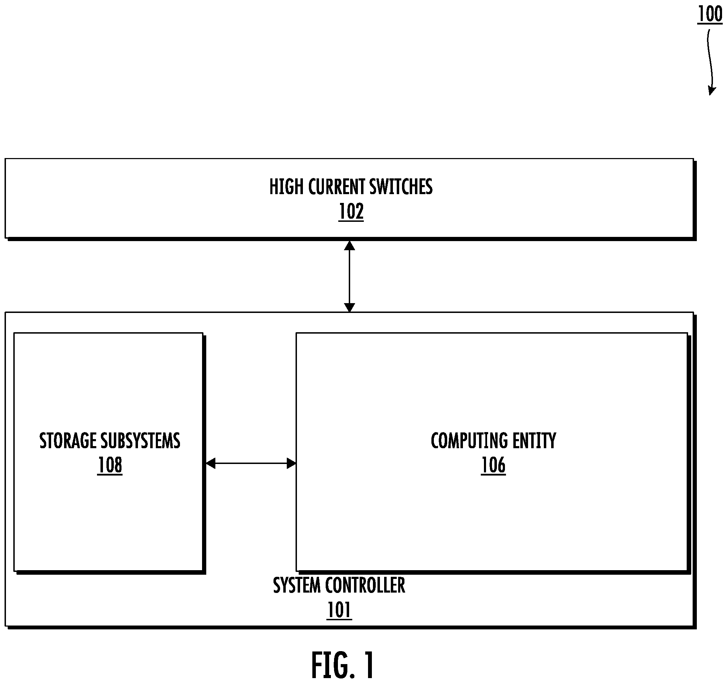

Referring now to FIG. 1, an electrical system 100 is provided, which may be used in accordance with various embodiments of the present disclosure. The electrical system 100 comprises a system controller 101 configured to receive gas composition and/or ionization signals from high current switches 102, process the gas composition and/or ionization signals, and operate the high current switches 102 based on the processing of the gas composition and/or ionization signals.

According to various embodiments of the present disclosure, processing the gas composition and/or ionization signals comprises determining, for the high current switches 102, one or more of (i) early signs of a leaking seal, (ii) broken seals, (iii) level of ionization within a high current switch, (iv) alarms/actions, or (v) trends that lead to ionization within a high current switch. In some embodiments, operating the high current switches 102 comprises toggling or transmitting an on/off signal based on the processing of the gas composition and/or ionization signals. In some embodiments, the system controller 101 allows switching of DC current at higher levels. For example, the system controller 101 may maximize operating points of high current switches 102 by increasing a DC current threshold of which the high current switches 102 are allowed to switch. As such, the high current switches 102 may be configured to operate at higher capacities by increasing DC current allowed to switch at the high current switches 102 until ionization is detected then of which, the amount of DC current allowed may be decreased and/or fine-tuned to allow operation of high current switches 102 at the most aggressive, but still at a safe level. In some embodiments, the system controller 101 also allows switching of alternating current (AC) current with more offset from zero transition.

In some embodiments, system controller 101 may communicate with at least one of the high current switches 102 via analog or digital signals using wired or wireless communication. In some example embodiments, system controller 101 operates in accordance with any of a number of wireless communication standards and protocols, such as infrared (IR) protocols, near field communication (NFC) protocols, Wibree, Bluetooth protocols, wireless universal serial bus (USB) protocols, and/or any other wireless protocol. In other example embodiments, system controller 101 operates in accordance with multiple wired or bus communication standards and protocols, such as Universal Asynchronous Receiver-Transmitter (UART), Serial Peripheral Interface (SPI), Inter-Integrated Circuit (I2C), or Controller Area Network (CAN).

The system controller further comprises a computing entity 106 and a storage subsystem 108. The computing entity 106 may be configured to receive gas composition and/or ionization signals from high current switches 102, process the gas composition and/or ionization signals, and operate the high current switches 102 based on the processing of the gas composition and/or ionization signals. The storage subsystem 108 may be configured to store input data used by the computing entity 106 to perform power management operations (e.g., controlling switching operation of high current switches 102.

The storage subsystem 108 may include one or more storage units, such as multiple distributed storage units that are connected through a computer network. Each storage unit in the storage subsystem 108 may store at least one of one or more data assets and/or one or more data about the computed properties of one or more data assets. Moreover, each storage unit in the storage subsystem 108 may include one or more non-volatile storage or memory media including, but not limited to, a floppy disk, flexible disk, hard disk, solid-state storage (SSS) (e.g., a solid-state drive (SSD), solid-state card (SSC), solid-state module (SSM)), enterprise flash drive, magnetic tape, or any other non-transitory magnetic medium, and/or the like. A non-volatile computer-readable storage medium may also include a punch card, paper tape, optical mark sheet (or any other physical medium with patterns of holes or other optically recognizable indicia), compact disc read only memory (CD-ROM), compact disc-rewritable (CD-RW), digital versatile disc (DVD), Blu-ray disc (BD), any other non-transitory optical medium, and/or the like. Such a non-volatile computer-readable storage medium may also include read-only memory (ROM), programmable read-only memory (PROM), erasable programmable read-only memory (EPROM), electrically erasable programmable read-only memory (EEPROM), flash memory (e.g., Serial, NAND, NOR, and/or the like), multimedia memory cards (MMC), secure digital (SD) memory cards, SmartMedia cards, CompactFlash (CF) cards, Memory Sticks, and/or the like. Further, a non-volatile computer-readable storage medium may also include conductive-bridging random access memory (CBRAM), phase-change random access memory (PRAM), ferroelectric random-access memory (FeRAM), non-volatile random-access memory (NVRAM), magnetoresistive random-access memory (MRAM), resistive random-access memory (RRAM), Silicon-Oxide-Nitride-Oxide-Silicon memory (SONOS), floating junction gate random access memory (FJG RAM), Millipede memory, racetrack memory, and/or the like.

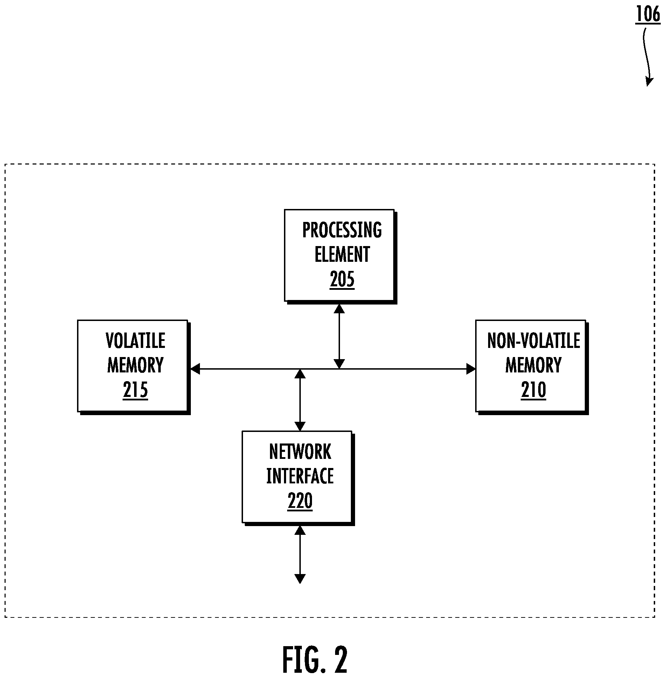

FIG. 2 provides an example computing entity 106 in accordance with some embodiments of the present disclosure. In general, the terms computing entity, computer, entity, device, system, and/or similar words used herein interchangeably may refer to, for example, one or more computers, computing entities, desktops, mobile phones, tablets, phablets, notebooks, laptops, distributed systems, kiosks, input terminals, servers or server networks, blades, gateways, switches, processing devices, processing entities, set-top boxes, relays, routers, network access points, base stations, the like, and/or any combination of devices or entities adapted to perform the functions, operations, and/or processes described herein. Such functions, operations, and/or processes may include, for example, transmitting, receiving, operating on, processing, displaying, storing, determining, creating/generating, monitoring, evaluating, comparing, and/or similar terms used herein interchangeably. In one embodiment, these functions, operations, and/or processes can be performed on data, content, information, and/or similar terms used herein interchangeably.

As indicated, in one embodiment, the computing entity 106 may also include one or more network interfaces 220 for communicating with various computing entities, such as by communicating data, content, information, and/or similar terms used herein interchangeably that can be transmitted, received, operated on, processed, displayed, stored, and/or the like.

As shown in FIG. 2, in one embodiment, the computing entity 106 may include, or be in communication with, one or more processing elements 205 (also referred to as processors, processing circuitry, and/or similar terms used herein interchangeably) that communicate with other elements within the computing entity 106 via a bus, for example. As will be understood, the processing element 205 may be embodied in a number of different ways.

For example, the processing element 205 may be embodied as one or more complex programmable logic devices (CPLDs), microprocessors, multi-core processors, coprocessing entities, application-specific instruction-set processors (ASIPs), microcontrollers, and/or controllers. Further, the processing element 205 may be embodied as one or more other processing devices or circuitry. The term circuitry may refer to an entirely hardware embodiment or a combination of hardware and computer program products. Thus, the processing element 205 may be embodied as integrated circuits, application specific integrated circuits (ASICs), field programmable gate arrays (FPGAs), programmable logic arrays (PLAs), hardware accelerators, other circuitry, and/or the like.

As will therefore be understood, the processing element 205 may be configured for a particular use or configured to execute instructions stored in volatile or non-volatile media or otherwise accessible to the processing element 205. As such, whether configured by hardware or computer program products, or by a combination thereof, the processing element 205 may be capable of performing steps or operations according to embodiments of the present disclosure when configured accordingly.

In one embodiment, the computing entity 106 may further include, or be in communication with, non-volatile media (also referred to as non-volatile storage, memory, memory storage, memory circuitry, and/or similar terms used herein interchangeably). In one embodiment, the non-volatile media includes one or more non-volatile storage or memory media 210, including, but not limited to, hard disks, ROM, PROM, EPROM, EEPROM, flash memory, MMCs, SD memory cards, Memory Sticks, CBRAM, PRAM, FeRAM, NVRAM, MRAM, RRAM, SONOS, FJG RAM, Millipede memory, racetrack memory, and/or the like.

As will be recognized, the non-volatile media may store databases, database instances, database management systems, data, applications, programs, program modules, scripts, source code, object code, byte code, compiled code, interpreted code, machine code, executable instructions, and/or the like. The term database, database instance, database management system, and/or similar terms used herein interchangeably may refer to a collection of records or data that is stored in a computer-readable storage medium using one or more database models, such as a hierarchical database model, network model, relational model, entity-relationship model, object model, document model, semantic model, graph model, and/or the like.

In one embodiment, the computing entity 106 may further include, or be in communication with, volatile media (also referred to as volatile storage, memory, memory storage, memory circuitry, and/or similar terms used herein interchangeably). In one embodiment, the volatile media includes one or more volatile storage or memory media 215, including, but not limited to, random access memory (RAM), dynamic random access memory (DRAM), static random access memory (SRAM), fast page mode dynamic random access memory (FPM DRAM), extended data-out dynamic random access memory (EDO DRAM), synchronous dynamic random access memory (SDRAM), double data rate synchronous dynamic random access memory (DDR SDRAM), double data rate type two synchronous dynamic random access memory (DDR2 SDRAM), double data rate type three synchronous dynamic random access memory (DDR3 SDRAM), Rambus dynamic random access memory (RDRAM), Twin Transistor RAM (TTRAM), Thyristor RAM (T-RAM), Zero-capacitor (Z-RAM), Rambus in-line memory module (RIMM), dual in-line memory module (DIMM), single in-line memory module (SIMM), video random access memory (VRAM), cache memory (including various levels), flash memory, register memory, and/or the like. It will be appreciated that where embodiments are described to use a computer-readable storage medium, other types of computer-readable storage media may be substituted for or used in addition to the computer-readable storage media described above.

As will be recognized, the volatile media may be used to store at least portions of the databases, database instances, database management systems, data, applications, programs, program modules, scripts, source code, object code, byte code, compiled code, interpreted code, machine code, executable instructions, and/or the like being executed by, for example, the processing element 205. Thus, the databases, database instances, database management systems, data, applications, programs, program modules, scripts, source code, object code, byte code, compiled code, interpreted code, machine code, executable instructions, and/or the like may be used to control certain aspects of the operation of the computing entity 106 with the assistance of the processing element 205 and operating system.

As indicated, in one embodiment, the computing entity 106 may also include one or more network interfaces 220 for communicating with various computing entities, such as by communicating data, content, information, and/or similar terms used herein interchangeably that can be transmitted, received, operated on, processed, displayed, stored, and/or the like. Such communication may be executed using a wired data transmission protocol, such as fiber distributed data interface (FDDI), digital subscriber line (DSL), Ethernet, asynchronous transfer mode (ATM), frame relay, data over cable service interface specification (DOCSIS), or any other wired transmission protocol. Similarly, the computing entity 106 may be configured to communicate via wireless external communication networks using any of a variety of protocols, such as general packet radio service (GPRS), Universal Mobile Telecommunications System (UMTS), Code Division Multiple Access 2000 (CDMA2000), CDMA2000 1X (1xRTT), Wideband Code Division Multiple Access (WCDMA), Global System for Mobile Communications (GSM), Enhanced Data rates for GSM Evolution (EDGE), Time Division-Synchronous Code Division Multiple Access (TD-SCDMA), Long Term Evolution (LTE), Evolved Universal Terrestrial Radio Access Network (E-UTRAN), Evolution-Data Optimized (EVDO), High Speed Packet Access (HSPA), High-Speed Downlink Packet Access (HSDPA), IEEE 802.11 (Wi-Fi), Wi-Fi Direct, 802.16 (WiMAX), ultra-wideband (UWB), IR protocols, NFC protocols, Wibree, Bluetooth protocols, wireless USB protocols, and/or any other wireless protocol.

Although not shown, the computing entity 106 may include, or be in communication with, one or more input elements, such as a keyboard input, a mouse input, a touch screen/display input, motion input, movement input, audio input, pointing device input, joystick input, keypad input, and/or the like. The computing entity 106 may also include, or be in communication with, one or more output elements (not shown), such as audio output, video output, screen/display output, motion output, movement output, and/or the like.

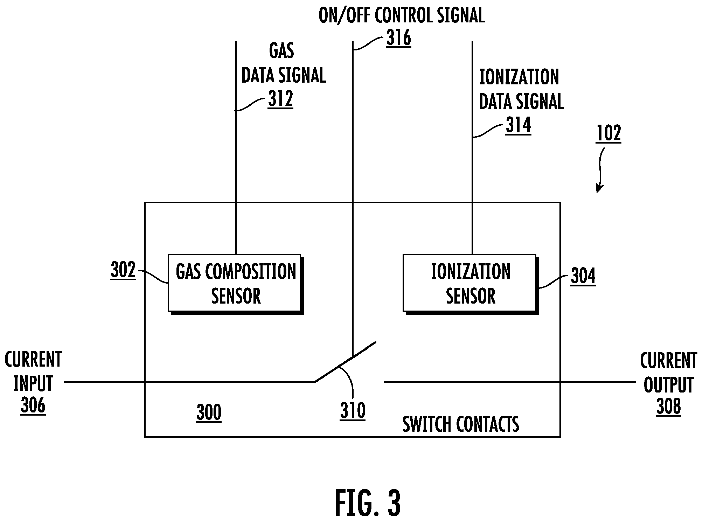

FIG. 3 depicts a high current switch in accordance with some embodiments of the present disclosure. High current switches 102 may comprise electrically controlled switches used for switching (e.g., from current input 306 to current output 308) electrical power circuits in a wide variety of applications that require switching of higher currents and voltages, such as in heating, ventilation, and air conditioning (HVAC), power supply, locomotives, elevator control, motor controls, aerospace and defense, hybrid cars, electric cars, and fuel cell vehicles, as well as electric vehicle (EV) charging systems. In some embodiments, high current switches 102 are used to handle high current loads and are designed to be directly connected to high-current load devices. In some embodiments, high current switches 102 comprise features for controlling and suppressing arcing produced between contact points (e.g., switch contacts 310) when they transition from a closed to an open circuit (break arc) or from an open to a closed (make arc) circuit. In some embodiments, high current switches 102 (e.g., assembly 300) are hermetically sealed and may be filled with a specific gas/gas mixture, such as hydrogen and nitrogen, to reduce damage to contacts from arcing, increase voltage rating, and generally improve contact life of the high current switches 102.

As depicted by FIG. 3, a given one of high current switches 102 comprises a gas composition sensor 302 and a gas ionization sensor 304 encapsulated within an assembly 300 (e.g., gas filled and hermetically sealed) of high current switch 102. According to various embodiment of the present disclosure, either one of gas composition sensor 302 or gas ionization sensor 304 is configured to determine an operating condition of high current switches 102 that may be representative of degradation, wear, or damage to assembly 300, which may lead to increased arcing and unsafe conditions. According to some alternative embodiments, assembly 300 comprises one of gas composition sensor 302 or ionization sensor 304.

Gas composition sensor 302 may comprise a sensor capable of detecting or determining a presence and/or concentration of various gases in the assembly 300, such as oxygen, carbon dioxide, nitrogen oxides, sulfur dioxide, hydrogen, and formaldehyde. In some embodiments, the gas composition sensor 302 comprises a MEMS sensor. Accordingly, gas composition sensor 302 may generate gas data signal 312 that is representative of the presence and/or concentration of various gases in the assembly 300. In some embodiments, the gas data signal 312 is received by system controller 101 for monitoring gas composition within the assembly 300. For example, gas composition sensor 302 may be used to monitor gas composition by detecting changes in gas composition within the assembly 300 and generating gas data signal 312 comprising one or more parameters associated with a current gas composition (e.g., thermal conductivity) in analog or digital form.

As further depicted by FIG. 3, a given one of high current switches 102 further comprises a gas ionization sensor 304 within the assembly 300. Gas ionization sensor 304 may comprise a sensor capable of detecting or determining a presence and/or amount of ionization present in the assembly 300. In some embodiments, the gas ionization sensor 304 comprises an ionization detection component, such as from a photoionization detector (PID) gas sensor. The gas ionization sensor 304 may be configured to determine changes in gas ionization level within assembly 300 and generate an ionization data signal 314 comprising one or more parameters associated with gas ionization in analog or digital form.

According to some alternative embodiments, gas ionization sensor 304 comprises an optical monitoring device, such as a photodiode, phototransistor, or any other suitable photosensitive sensor or photodetector capable of monitoring a brightness and/or duration of sparks (e.g., arcing) when contact is made between switch contacts 310. That is, gas ionization sensor 304 may measure gas ionization via photodetection. If gas composition within assembly 300 is compromised (due to leaks) or contact surfaces of switch contacts 310 start to degrade, a resulting change in ionization spark characteristics may occur. For example, as gas composition and spark characteristics evolve within assembly 300, electrically excited optical spectral bands may also change. In some embodiments, gas ionization sensor 304 may comprise a spectrometer sensor and/or optical/spectral filters configured to determine or evaluate spectral content of ionization sparks (e.g., arcing caused by the switch contacts 310).

According to various embodiments of the present disclosure, assembly 300 further comprises (and encapsulates) switch contacts 310 that allows high current switch 102 to switch a current input 306 to a current output 308. Switch contacts 310 are controllable by an on/off control signal 316 that may be received from system controller 101. In some embodiments, system controller 101 generates on/off control signal 316 based on gas data signal 312 and ionization data signal 314. That is, system controller 101 may determine whether switch contacts 310 should be open or closed based on gas data signal 312 and/or ionization data signal 314 representative of operating conditions of high current switch 102. For example, one or more of gas data signal 312 or ionization data signal 314 may indicate excessive arcing and/or potentially unsafe operating conditions. System controller 101 may toggle on/off control signal 316 to open and close switch contacts 310 based on predetermined tolerances such that electrical current received at current input 306 may be safely switched to current output 308.

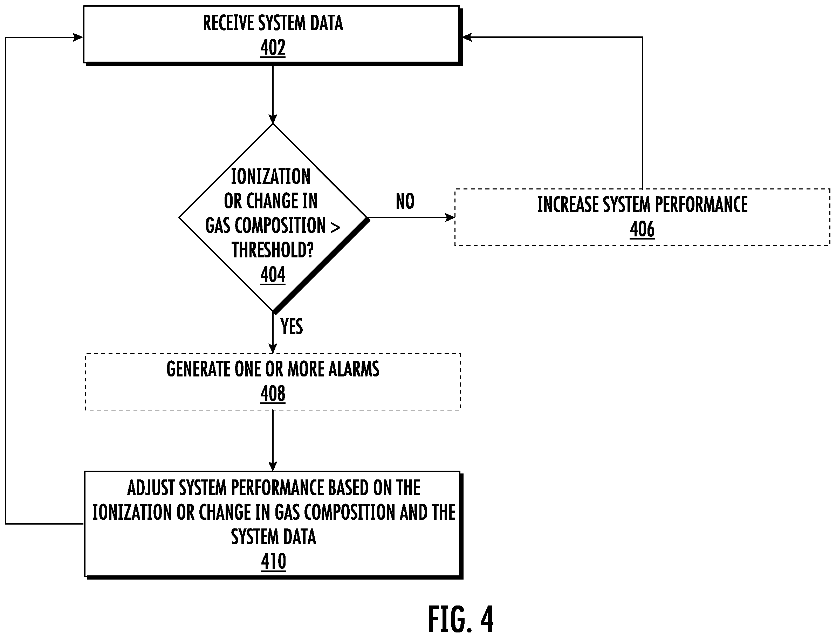

Referring now to FIG. 4, an example flow diagram illustrating an exemplary method for monitoring and controlling an electronics system comprising one or more high current switches in accordance with some example embodiments of the present disclosure. It is noted that each block of a flowchart, and combinations of blocks in the flowchart, may be implemented by various means such as hardware, firmware, circuitry, and/or other devices associated with execution of software including one or more computer program instructions. For example, one or more of the steps/operations described in FIG. 4 may be embodied by computer program instructions, which may be stored by a non-transitory memory of an apparatus employing an embodiment of the present disclosure and executed by a processor component in an apparatus (such as, but not limited to, system controller 101). For example, these computer program instructions may direct the processor component to function in a particular manner, such that the instructions stored in the computer-readable storage memory produce an article of manufacture, the execution of which implements the function specified in the flowchart block(s).

In FIG. 4, the example method 400 may be executed by a computing device associated with an electronics system comprising one or more high current switches (for example, as illustrated and described above in connection with at least FIG. 3). At step/operation 402, system data is received. In some embodiments, the system data comprises sensor data (e.g., gas data signal 312 and/or ionization data signal 314) from each of high current switches 102 and system parameters, such as an input current and/or voltage with respect to high current switches 102, DC transient ramp speed, or AC zero transition.

In some embodiments, subsequent to step/operation 402, the example method proceeds to step 404, where the system data is monitored for ionization or a change in gas composition associated with one or more of high current switches 102 exceeding a threshold. Monitoring the system data (e.g., sensor data) may comprise determining, for each of the high current switches 102, a presence and/or amount of ionization or a change in gas composition in assembly 300. In some embodiments, monitoring the system data comprises determining one or more of (i) early signs of a leaking seal of a high current switch 102, (ii) a broken seal of a high current switch 102, (iii) a level of ionization within the assembly 300 of a high current switch 102, (iv) alarms or actions that should be generated in response to the system data, or (v) trends that lead to ionization happening within the assembly 300 of a high current switch 102.

The ionization or change in gas composition may be monitored to determine dynamic constraints imposed on the electronics system by real-time or near real-time conditions of the one or more high current switches 102. According to various embodiments of the present disclosure, performance or output of the electronics system is varied based on the operating capacities or conditions of high current switches 102. That is, changes in performance or operation of the electronics system may be proportional to and limited by the functionality or capability of high current switches 102.

In some embodiments, absent ionization or a change in gas composition greater than a threshold in any of the high current switches 102, subsequent to step/operation 404, the example method proceeds to optional step/operation 406, where system performance is increased. Increasing performance of an electronics system may comprise, e.g., via system controller 101, switching of DC current at higher levels or switching of AC current with more offset from zero transition to achieve operation of an electronics system that is faster, more powerful, or improved in any performance criteria requiring increased or greater utilization of electrical energy or power. However, increasing system performance may cause an increase in switching burden on high current switches 102 and may lead to increased ionization. In some embodiments, increased performance of an electronics system may be achieved in conjunction with the monitoring of ionization or change in gas composition to maintain component integrity and safety.

In some embodiments, subsequent to step/operation 406, the example method proceeds to steps/operations 402 and 404, where updated system data reflecting the increase in system performance is received and ionization or change in gas composition is monitored based on the updated system data.

In some embodiments, if ionization or a change in gas composition is greater than the threshold in any of the high current switches 102, subsequent to step/operation 404, the example method proceeds to optional step 408, where one or more alarms are generated based on the determination/detection of ionization or change in gas composition greater than the threshold.

In some embodiments, if ionization or a change in gas composition is greater than the threshold in any of the high current switches 102, subsequent to step(s)/operation(s) 404 or 408, the example method proceeds to step 410, where system performance of the electronics system is adjusted based on (i) the determination that the ionization or change in gas composition is greater than the threshold and (ii) the system data (e.g., to determine input current and/or voltage, or DC transient ramp speed/AC zero transition).

In some example embodiments, a presence or increased presence of ionization in high current switches 102 may be associated with arcing that may occur when operating the high current switches 102 at or near maximum rated thresholds. To minimize arcing for the purposes of safety, operation of an electronics system comprising the high current switches 102 may be throttled or reduced by, for example, system controller 101, to minimize ionization of high current switches 102. For example, a system controller may determine input current and/or voltage at the one or more high current switches 102 and vary operation of electronics system by decreasing the input current and/or voltage in response to the determined/detected presence and/or amount of the ionization or change in gas composition. In some example embodiments, if ionization is detected based on the system data, system parameters, such as DC transient ramp speed/AC zero transition or operating current, may be reduced or adjusted, for example, by system controller 101, to reduce stress on the high current switches 102 and operate at a point where sparks or arcing is reduced.

Similarly, a change in gas composition in high current switches 102 may be associated with a seal leak or damage to the high current switches 102. A system controller 101 may reduce electrical stress on the high current switches 102 to ensure continued safe operation of the high current switches 102 until replacement or repair. In some example embodiments, if gas composition has changed indicating a leaking or broken seal based on the system data, electrical stress may be reduced on the high current switches 102 by lowering current level or slower DC transient ramp/AC zero transition to ensure continued safe operation of the high current switches 102. In some embodiments, configuring the system performance comprises determining a rate of opening or closing switch contacts 310 (e.g., via on/off control signal 316). For example, a timing associated with opening or closing the switch contacts 310 may be determined to minimize sparks and/or arc.

It is to be understood that the disclosure is not to be limited to the specific embodiments disclosed, and that modifications and other embodiments are intended to be included within the scope of the appended claims. Although specific terms are employed herein, they are used in a generic and descriptive sense only and not for purposes of limitation, unless described otherwise.

## Claims

1. A current switch comprising:
one or more of a gas composition sensor or a gas ionization sensor configured to (i) determine a condition associated with the current switch and (ii) generate respective one or more of a gas data signal or an ionization data signal; and
a plurality of switch contacts configured to (i) receive a control signal from a system controller and (ii) switch a current input to a current output based on the control signal, wherein the control signal is generated by the system controller based at least in part on one or more of the gas data signal or the ionization data signal.

2. The current switch of claim 1, wherein the condition is representative of degradation, wear, or damage to an assembly comprising the current switch.

3. The current switch of claim 1, wherein the gas composition sensor comprises a micro-electromechanical system sensor.

4. The current switch of claim 1, wherein the gas ionization sensor comprises (i) an ionization detection component of a photoionization detector gas sensor, (ii) an optical monitoring device including a photosensitive sensor or a photodetector, (iii) a photosensitive sensor configured to monitor brightness and/or duration of arcing caused by the plurality of switch contacts, or (iv) a spectrometer or one or more spectral filters configured to determine spectral content of arcing caused by the plurality of switch contacts.

5. The current switch of claim 1, wherein the gas composition sensor comprises a sensor configured to determine a presence and/or concentration of one or more gases in the assembly.

6. The current switch of claim 1, wherein the gas data signal is representative of a presence and/or concentration of one or more gases in the assembly.

7. The current switch of claim 1, wherein the gas ionization sensor comprises a sensor configured to determine a presence and/or amount of ionization in the assembly.

8. A method comprising:
receiving, by one or more processors, system data, the system data comprising a gas data signal and/or an ionization data signal from a current switch;
determining, by the one or more processors, one or more of (i) a presence or amount of ionization or (ii) a change in gas composition, is greater than a threshold based on the system data;
adjusting, by the one or more processors, performance of an electronics system by generating a control signal based on the determination that the presence or amount of ionization or the change in gas composition is greater than the threshold; and
transmitting the control signal to the current switch.

9. The method of claim 8, wherein the system data comprises one or more of an input current or voltage with respect to the current switch, a direct current transient ramp speed, or an alternating current zero transition.

10. The method of claim 8 further comprising determining one or more of (i) an indication of a leaking seal associated with the current switch, (ii) a broken seal associated with the current switch, (iii) one or more alarms responsive to the system data, or (iv) a trend leading to ionization associated with the current switch.

11. The method of claim 8 further comprising increasing performance of the electronics system based on an absence of the determination that the presence or amount of ionization or the change in gas composition is greater than the threshold.

12. The method of claim 11, wherein increasing performance of the electronics system comprises switching of direct current at higher levels or switching of alternating current with greater offset from zero transition.

13. The method of claim 11, wherein adjusting performance of the electronics system comprises decreasing an input voltage or current.

14. The method of claim 11, wherein adjusting performance of the electronics system comprises decreasing direct current transient ramp speed or alternative current zero transition.

15. The method of claim 11, wherein adjusting performance of the electronics system comprises determining a rate of opening or closing a plurality of switch contacts associated with the current switch.
